# EUROPEAN PATENT APPLICATION

(11) **EP 4 606 496 A1**
(43) Date of publication of application: **27.08.2025**
(21) Application number: 24866595.2
(22) Date of filing: 22.04.2024
(51) Int. Cl.: B09B 3/40, B09B 101/15

(54) **METHOD FOR RECYCLING SOLAR WASTE PANEL**

(30) Priority: 09.01.2024 KR 20240003540
(71) Applicant: Korea Zinc Co., Ltd., Seoul 03159 (KR)
(72) Inventor: BYUN, Seong Jin, Seoul 01601 (KR); JEONG, Chan Ki, Seoul 01882 (KR); KANG, Sung Moon, Ulsan 45003 (KR)
(74) Representative: Angerhausen, Christoph
(86) International application number: PCT/KR2024/005402
(87) International publication number: WO 2025/150619

(57) **Abstract**

According to the one embodiment of the present invention, a method of recycling a waste solar panel including a glass substrate, solar cells, an adhesive layer provided between the glass substrate and the solar cells to bond the glass substrate and the solar cells, and a metal frame configured to fix a laminated structure of the glass substrate, the adhesive layer, and the solar cells, the method comprising: a first crushing process of crushing the waste solar panels to a predetermined size or less; a frame removal process of sorting and removing the frame contained in a first crushed material crushed by the first crushing process; a second crushing process of crushing the first crushed material from which the frame has been removed by the frame removal process to a predetermined size or less; a roasting process of removing the adhesive layer between the glass substrate and the solar cells by inputting a second crushed material crushed by the second crushing process into a roasting furnace and heating the second crushed material; a classification process of separating the second crushed material that has undergone the roasting process into the glass substrate and the solar cells, and removing the glass substrate; and a dry furnace input process of inputting a final crushed material from which the glass substrate has been removed into a dry furnace of a smelting process.

## Description

### TECHNICAL FIELD

The present disclosure relates to a method for recycling a waste solar panel.

### BACKGROUND

Solar power generation is attracting attention as a renewable energy source because it has a small environmental load by using clean sunlight energy. A solar panel used for this solar power generation includes a glass substrate, solar cells, an adhesive layer such as ethylene vinyl acetate (EVA) that is interposed between the solar cells and the glass substrate and bonds the solar cells and the glass substrate, an aluminum frame that secures the glass substrate, the adhesive layer, the solar cells, and the like into one module, and the like.

Regarding the use of solar power generation, the proportion of renewable energy power generation has increased rapidly since the early 2000s, and in particular, the proportion of solar power generation has increased the most.

As the spread of solar power generation systems expands, the number of used solar power panels that have reached the end of their lifespan is expected to increase exponentially. Considering that the lifespan of solar panels is approximately 25 years, as solar panels, which have been installed since the early 2000s, nearing the end of their lifespan, it is expected that a large number of waste solar panels will begin to appear from the mid to late 2020s. Accordingly, various methods for processing waste solar panels are being sought. However, so far, all waste solar panels have been landfilled without recycling, or only the aluminum frames have been separated and recycled, and complete recycling of waste solar modules has not yet been realized. Specifically, the currently existing waste solar panel processing method is to manually separate the aluminum frames and glass for selling, and landfill the remaining parts of the sloar cells. There are some companies that have attempted to semi-automate and automate the process of separating aluminum frames and glass using machines, but most of the companies are small and have a small processing capacity.

In particular, solar cells, which are rich in silicon and contain significant amounts of copper and silver, are not easily recycled, and complex processes are required to separate valuable metals by recycling them through general crushing and sorting methods. Accordingly, there is a need to develop a recycling method that is capable of handling this, and there is also a need to develop an automated process that is capable of processing solar panels in large quantities.

### SUMMARY

The present disclosure provides a method of replacing a flux made of silicon dioxide (SiO₂) used in a smelting process with a waste solar panel by inputting the waste solar panel into a smelting furnace that performs a smelting process for recovering valuable metals.

In addition, the present disclosure provides a method of recovering a valuable metal-concentrated material from a waste solar panel.

According to the one embodiment of the present invention, a method of recycling a waste solar panel including a glass substrate, solar cells, an adhesive layer provided between the glass substrate and the solar cells to bond the glass substrate and the solar cells, and a metal frame configured to fix a laminated structure of the glass substrate, the adhesive layer, and the solar cells, the method comprising: a first crushing process of crushing the waste solar panels to a predetermined size or less; a frame removal process of sorting and removing the frame contained in a first crushed material crushed by the first crushing process; a second crushing process of crushing the first crushed material from which the frame has been removed by the frame removal process to a predetermined size or less; a roasting process of removing the adhesive layer between the glass substrate and the solar cells by inputting a second crushed material crushed by the second crushing process into a roasting furnace and heating the second crushed material; a classification process of separating the second crushed material that has undergone the roasting process into the glass substrate and the solar cells, and removing the glass substrate; and a dry furnace input process of inputting a final crushed material from which the glass substrate has been removed into a dry furnace of a smelting process.

In the first crushing process, the waste solar panel into a size of 150 mm or less, and in the second crushing process, the first crushed material is crushed into a size of 50 mm or less.

The first crushing process and the second crushing process are performed through a crusher, and the first crushed material crushed into the size of 150 mm or less in the first crushing process and the second crushed material crushed into the size of 50 mm or less in the second crushing process are discharged through a screen provided at a bottom of the crusher.

The metal frame is made of aluminum, and the frame removal process is performed by a eddy current separator.

The roasting process is performed at a temperature of 500 degrees C to 600 degrees C for 2 to 3 hours.

The adhesive layer is made of ethylene vinyl acetate (EVA), and the ethylene vinyl acetate is removed by combustion or sublimation through the roasting process.

The classification process is performed through sieving classification using a difference in particle size between the crushed glass substrate and the crushed solar cells.

The final crushed material from which the glass substrate has been removed contains silicon (Si), silver (Ag), and copper (Cu).

The silver and the copper are concentrated from the final crushed material through the classification process.

An amount of the final crushed material input into the dry furnace in the dry furnace input process is calculated based on a composition ratio of silicon dioxide in a flux input into the smelting process.

According to the present disclosure, recycled casting sand (including SiO₂), which is input as one of the fluxs in a smelting process, can be replaced with a waste solar panel.

In addition, valuable metals such as silver and copper contained in a waste solar panel can be concentrated and recovered.

### BRIEF DESCRIPTION OF THE DRAWINGS

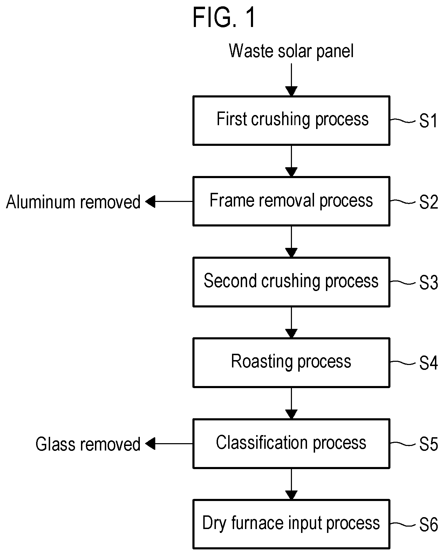

FIG. 1 is a process flowchart of a method for recycling a waste solar panel according to an embodiment of the present disclosure.

### DETAILED DESCRIPTION

In describing the present disclosure, when it is determined that related known functions are obvious to those skilled in the art and a detailed description of the functions unnecessarily obscures the gist of the present disclosure, the detailed description will be omitted.

The present disclosure relates to a method of recycling a waste solar panel by using an existing smelting process. The recycling method according to the present disclosure is mainly recycling using a waste solar panel, but is not necessarily limited thereto, and all industrial waste containing silicon and valuable metals can be subject to the recycling method according to the present disclosure.

The present disclosure provides a method of processing waste solar panel and inputting the processed waste solar panel into a dry furnace that performs a conventional smelting process, thereby replacing silicon dioxide input in the smelting process and recovering valuable metals contained in the waste solar panel.

FIG. 1 is a process flowchart of a method for recycling a waste solar panel according to an embodiment of the present disclosure.

A waste solar panel subject to recycling of the present disclosure includes a glass substrate, solar cells, an adhesive layer provided between the glass substrate and the solar cells to bond the glass substrate and the solar cells, and a metal frame configured to fix a laminated structure of the glass substrate, the adhesive layer, and the solar cells, and provided on the peripheral edge of a solar panel.

Referring to FIG. 1, a waste solar panel is input into a crusher, and the waste solar panel is crushed by the crusher into a size of 150 mm or less (first crushing process S1). The first crushing process S1 is performed by using a crusher, in which the waste panel is crushed into the size of 150 mm or less by the first crushing process S1, and the crushed waste panel is discharged as a first crushed material through a screen provided at the bottom of the crusher. Any mechanism that can crush a glass substrate, solar cells, a metal frame, and the like contained in the waste solar panel may be used as the mechanism to perform the first crushing process S1. For example, a known crusher such as a uniaxial crusher or a biaxial crusher may be used.

The first crushed material crushed by the first crushing process S1 is transferred to a frame removal process S2, and in the frame removal process S2, the metal frame material contained in the first crushed material is sorted and removed from the first crushed material. The first crushed material obtained by crushing the waste solar panel contain metal frame materials that held the laminated structure of the waste solar panel, and the metal frame may be made of aluminum. The first crushed material containing the crushed aluminum frame is transferred to a eddy current separator, and the eddy current separator is capable of sorting and removing the crushed aluminum frame from the first crushed material. The eddy current separator uses eccentric eddy current technology to sort small, crushed, and light non-ferrous metals such as aluminum, and is equipped with an angle-adjustable magnet that has a strong magnetic field to be capable of sorting and separating the aluminum components contained in the first crushed material.

The first crushed material from which the aluminum frame has been removed by the frame removal process S2 is transferred to a second crushing process S3. In the second crushing process S3, the first crushed material is crushed to a size of 50 mm or less. The second crushing process S3 is performed by using a crusher, in which the waste panel is crushed into the size of 50 mm or less by the second crushing process S3, and the first crushed material is discharged as a second crushed material through a screen provided at the bottom of the crusher. The second crushing process S3 may be performed in the same way as the first crushing process S1, in which the first crushed material may be crushed to a size (50 mm or less) smaller than a target crushed size (150 mm or less) in the first crushing process S1 by appropriately adjusting the number of blades of the crusher, a blade clearance, blade rotation speed, and the like.

The second crushed material crushed by the second crushing process S3 is input into a sintering process S4. In the roasting process S4, the second crushed material is input into a roasting furnace and heated to remove the adhesive layer between the glass substrate and the solar cells from the second crushed material. The adhesive layer may be made of ethylene vinyl acetate (EVA). The roasting process S4 may be performed in the roasting furnace at a temperature of 500 degrees C to 600 degrees C for 2 to 3 hours. Through the roasting process S4, the EVA adhesive layer between the glass substrate and the solar cells may be removed from the second crushed material by combustion or sublimation. When the roasting process S4 is completed, the adhesive layer is removed, leaving only the crushed glass substrate and solar cell. In particular, the solar cells remain in the form of powder through a high-temperature roasting process in the roasting process, while the crushed glass substrate has a particle size similar to that before being input into the roasting furnace.

The second crushed material that has gone through the roasting process S4 contains the crushed glass substrate and solar cell, and the glass substrate and solar cell included in the second crushed material may be separated through a classification process S5. The classification process S5 may be performed through sieving classification using the difference in particle size between the glass substrate and the solar cells contained in the second crushed material after the roasting process S4. After going through the sintering process S4, the second crushed material contains the solar cells in the form of powder and the glass substrate with larger particle sizes than the solar cells. Therefore, the glass substrate with larger particle sizes can be separated from the solar cells in the form of powder and removed through the classification process S5. The solar cells in the form of powder from which the glass substrate has been removed are the final crushed material and may contain silicon (Si), silver (Ag), copper (Cu), and the like.

As described above, by removing the glass substrate, resin, and other impurities through the classification process S5, valuable metals contained in the solar cells, such as silver and copper, can be concentrated.

The final crushed material from which the glass substrate has been removed through the classification process S5 is input into the dry furnace of the smelting process (dry furnace input process S6). Not only can valuable metals such as silver and copper be recovered from a waste solar panel by recycling the final crushed material containing silicon (Si), silver (Ag), and copper (Cu) as a flux and fuel for the smelting process, but also the amount of a flux and fuel input into the smelting process can be dramatically reduced.

Specifically, in the smelting process, a flux is input to increase the fluidity of melt, and in particular, when metal waste is used as a raw material, the input of the flux is even more necessary. This is because natural ore itself contains a large amount of flux components such as SiO₂ and Al₂O₃, but the content of such flux components is insufficient in metal waste. Accordingly, the input of a flux is essential in the smelting process of metal waste, and previously, sand or recycled casting sand was mainly used as a silicon dioxide (SiO₂) flux. In the present disclosure, the final crushed material containing silicon (Si), silver (Ag), copper (Cu), and the like obtained from a waste solar panel is input into a dry furnace of a smelting process, and silicon (Si), which is the main component of the final crushed material, reacts with oxygen in the dry furnace to produce silicon dioxide (SiO₂), thereby functioning as a flux. That is, a flux made of silicon dioxide (SiO₂) input into a smelting process can be replaced by recycling a waste solar panel by inputting the waste solar panel into the smelting furnace that performs a smelting process for recovering valuable metals. The amount of final crushed material input into the dry furnace in the dry furnace input process S6 may be calculated based on the composition ratio of silicon dioxide in the flux input into the smelting process.

While the present disclosure has been described in connection with some embodiments thereof, it shall be understood that various modifications and changes can be made without departing from the fundamental principles and technical scope of the present disclosure, which may be apparent to a person ordinarily skilled in the art, to which the present disclosure belongs. In addition, such modifications and changes should be considered to fall within the scope of the claims appended hereto.

## Claims

1. A method of recycling a waste solar panel including a glass substrate, solar cells, an adhesive layer provided between the glass substrate and the solar cells to bond the glass substrate and the solar cells, and a metal frame configured to fix a laminated structure of the glass substrate, the adhesive layer, and the solar cells, the method comprising:
a first crushing process of crushing the waste solar panels to a predetermined size or less;
a frame removal process of sorting and removing the frame contained in a first crushed material crushed by the first crushing process;
a second crushing process of crushing the first crushed material from which the frame has been removed by the frame removal process to a predetermined size or less;
a roasting process of removing the adhesive layer between the glass substrate and the solar cells by inputting a second crushed material crushed by the second crushing process into a roasting furnace and heating the second crushed material;
a classification process of separating the second crushed material that has undergone the roasting process into the glass substrate and the solar cells, and removing the glass substrate; and
a dry furnace input process of inputting a final crushed material from which the glass substrate has been removed into a dry furnace of a smelting process.

2. The method of Claim 1, wherein, in the first crushing process, the waste solar panel into a size of 150 mm or less, and in the second crushing process, the first crushed material is crushed into a size of 50 mm or less.

3. The method of Claim 2, wherein the first crushing process and the second crushing process are performed through a crusher, and
the first crushed material crushed into the size of 150 mm or less in the first crushing process and the second crushed material crushed into the size of 50 mm or less in the second crushing process are discharged through a screen provided at a bottom of the crusher.

4. The method of Claim 1, wherein the metal frame is made of aluminum, and the frame removal process is performed by a eddy current separator.

5. The method of Claim 1, wherein the roasting process is performed at a temperature of 500 degrees C to 600 degrees C for 2 to 3 hours.

6. The method of Claim 5, wherein the adhesive layer is made of ethylene vinyl acetate (EVA), and
the ethylene vinyl acetate is removed by combustion or sublimation through the roasting process.

7. The method of Claim 1, wherein the classification process is performed through sieving classification using a difference in particle size between the crushed glass substrate and the crushed solar cells.

8. The method of Claim 7, wherein the final crushed material from which the glass substrate has been removed contains silicon (Si), silver (Ag), and copper (Cu).

9. The method of Claim 8, wherein the silver and the copper are concentrated from the final crushed material through the classification process.

10. The method of Claim 1, wherein an amount of the final crushed material input into the dry furnace in the dry furnace input process is calculated based on a composition ratio of silicon dioxide in a flux input into the smelting process.
